(19) Europäisches Patentamt
European Patent Office
Office européen des brevets

(11) **EP 2 786 542 B1**

(12) **EUROPÄISCHE PATENTSCHRIFT**

(45) Veröffentlichungstag und Bekanntmachung des Hinweises auf die Patenterteilung:
**09.03.2016 Patentblatt 2016/10**

(21) Anmeldenummer: **12808702.0**

(22) Anmeldetag: **04.12.2012**

(51) Int Cl.:
**H04L 27/20** (2006.01)     **H04L 27/36** (2006.01)

(86) Internationale Anmeldenummer:
**PCT/EP2012/074326**

(87) Internationale Veröffentlichungsnummer:
**WO 2013/083550 (13.06.2013 Gazette 2013/24)**

(54) **SENDERFRONTENDVORRICHTUNG ZUR ERZEUGUNG VON AUSGANGSSIGNALEN AUF BASIS MEHRPHASIGER MODULATION**

TRANSMITTER FRONT-END DEVICE FOR GENERATING OUTPUT SIGNALS ON THE BASIS OF A MULTIPHASE MODULATION

DISPOSITIF DE GÉNÉRATION DES SIGNAUX DE SORTIE SUR LA BASE D'UNE MODULATION POLYPHASÉE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **04.12.2011 DE 102011119915**

(43) Veröffentlichungstag der Anmeldung:
**08.10.2014 Patentblatt 2014/41**

(73) Patentinhaber: **RWTH Aachen**
**52062 Aachen (DE)**

(72) Erfinder:
• **NEGRA, Renato**
**52074 Aachen (DE)**
• **THIEL, Björn, Thorsten**
**52064 Aachen (DE)**

(74) Vertreter: **Schmelcher, Thilo**
**RCD-Patent**
**Postfach 3106**
**52118 Herzogenrath (DE)**

(56) Entgegenhaltungen:
**US-A1- 2004 192 229**

• **HARRIS F ET AL: "On synthesizing high speed sigma-delta dacs by combining the outputs of multiple low speed sigma-delta dacs", CONFERENCE RECORD OF THE 36TH. ASILOMAR CONFERENCE ON SIGNALS, SYSTEMS, & COMPUTERS, Bd. 2, 3. November 2002 (2002-11-03), Seiten 1050-1054, XP010638363, NY,US DOI: 10.1109/ACSSC.2002.1196944 ISBN: 978-0-7803-7576-5**

EP 2 786 542 B1

**Beschreibung**

Die Erfindung betrifft eine Senderfrontendvorrichtung zur Erzeugung von Ausgangssignalen auf Basis mehrphasiger Modulation.

Hintergrund der Erfindung

Gegenwärtig ist ein starker Trend hin zu sogenannten Software Defined Radio (SDR) Anwendungen zu verzeichnen. Dieser Trend ist unter anderem dadurch begünstigt, dass SDR Konzepte es ermöglichen, ein zur Verfügung stehendes Spektrum dynamisch auszuschöpfen. Dieser Trend erfordert jedoch auch besonders flexible Hochfrequenzsendeeinrichtungen. Die Anforderungen steigen zudem, da zunehmend mehrere Spektren und/oder mehrere Funkstandards durch die Hochfrequenzsendeeinrichtung bereitgestellt werden sollen. So finden sich beispielsweise in modernen Telefonen, Laptops und Tablet PCs eine Vielzahl unterschiedlicher Funksysteme mit unterschiedlichen Modulationsschemen und/oder unterschiedlichen Bandbreiten und/oder unterschiedlichen Frequenzen. Beispielhaft seien hierfür LTE (Long Term Evolution), 3G (3rd generation mobile telecommunication network), WiMAX (Worldwide Interoperability for Microwave Access), Wireless LAN oder Bluetooth als Beispiel für sogenannte Nahfeldkommunikation (Near Field Communication) erwähnt.

Gleichzeitig steigen jedoch die Anforderungen an die Energieeffizienz sowohl der mobilen Geräte als auch der jeweiligen Basisstationen. Die Energieeffizienz mobiler Geräte ist ein wichtiges Merkmal, um die Betriebszeit zu maximieren, während die Energieeffizienz von Basisstationen sowohl die sogenannten OPEX (Operation Expediture) direkt als auch mittelbar über die zu kühlende Verlustwärme beeinflusst wird.

Diese Anforderungen sind jedoch nur schwer in Übereinstimmung zu bringen, da eine erhöhte Komplexität durch die Bereitstellung verschiedenster Übertragungssysteme als auch durch die Rekonfigurierbarkeit steigt und somit in aller Regel auch die Verlustleistung steigt, auf der anderen Seite jedoch die Energieeffizienz nicht abnehmen sondern erheblich zunehmen soll.

Weiterhin ist zu verzeichnen, dass die zunehmende Vernetzung digitaler Geräte und die Vielzahl von Funksystemen auch zu einem Trend geführt haben, der eine verstärkte Digitalisierung der Hochfrequenzsendeeinrichtung selbst nach sich zieht. Diese Entwicklung ist durch die dadurch ermöglichte erhöhte Geschwindigkeit, geringere Leistungsaufnahme bei schrumpfenden Strukturen des CMOS Prozesses begünstigt. Daher kann eine gewünschte Rekonfigurierbarkeit in sogenannten "digital centric transmitter" basierten Lösungen durch Anpassung von digitalen Einstellungen für Filter und Kerne ermöglicht werden. Dieser Ansatz, welcher die digitalen Signale somit näher an die Antenne führt, wirft jedoch die Frage auf, wo innerhalb der Sendekette das digitale Eingangssignal in ein analoges Signal gewandelt werden soll.

Die Verwendung von sogenannten "switching-mode power amplifiers" (SMPAs), auch Schaltverstärker genannt, erlaubt die Anforderungen an eine erhöhte Rekonfigurierbarkeit als auch eine erhöhte Energieeffizienz zu erfüllen. Dies ist dadurch möglich, dass diese Verstärker eine sehr hohe Effizienz erreichen können, die theoretischerweise bei 100 % liegt. Diese Verstärker benötigen zudem nur ein treibendes digitales Signal, womit digitale Signale bis zum Verstärker verwendet werden können. Verschiedenste Verfahren können dabei verwendet werden, um ein digitales Signal zu erzeugen, das ein analoges Signal repräsentiert, welches durch Filterung wieder hergestellt werden kann. Ein mögliches Verfahren ist die DeltaSigma-Modulation ($\Delta\Sigma$-Modulation / DS-Modulation). Bei der $\Delta\Sigma$-Modulation wird ein analoges oder ein auch mehrstufiges digitales Signal in einen Einbit-Strom gewandelt während das Inband-Quantisierungsrauschen durch Rauschformung reduziert wird.

Das Hauptkonzept der $\Delta\Sigma$-Modulation ist es, das Quantisierungsrauschen in einen Frequenzbereich zu verschieben, der außerhalb des verwendeten Frequenzbandes liegt. Zu diesem Zweck wird die Differenz aus einem Quantisier-Eingangssignal y[n] und dem Quantisier-Ausgangssignal v[n] als Fehlersignal e[n] berechnet. Dieses Fehlersignal wird mittels einer Übertragungsfunktion H(z) gefiltert und auf den Eingang des Quantisierers rückgeführt. Die Übertragungsfunktion H(z) des Filters sorgt nun auf Grund ihrer definierten Eigenschaft dafür, dass das Quantisierungsrauschen in einen Bereich außerhalb des Nutzbereiches verschoben wird. Die Ordnung des $\Delta\Sigma$-Modulators wird dabei durch die Ordnung des Filters H(z) bestimmt. Um die spektralen Anforderungen zu erfüllen, muss in aller Regel das Ausgangssignal gefiltert, um dieses Rauschen zu entfernen. Häufig werden hierzu Filter mit hohen Anforderungen benötigt.

Ein Beispiel eines solchen Implementierungskonzepts ist beispielsweise in der Patentschrift US2004/192229 A1 zu finden. 2

$\Delta\Sigma$-Modulatoren können im wesentlichen in drei Gruppen eingeteilt werden, nämlich sogenannte Bandpass (BP), Hochpass (HP) und Tiefpass (LP) $\Delta\Sigma$-Modulatoren, wobei die Art der Rauschfilterung für die Gruppe bezeichnend ist.

Je nach verwendetem Typ von $\Delta\Sigma$-Modulator müssen unterschiedliche Dinge berücksichtigt werden.

Bandpass $\Delta\Sigma$M (BP$\Delta\Sigma$M / BPDSM) arbeiten auf Frequenzen, welche höher als die Trägerfrequenzen sind. Weiterhin sind während einer Trägerperiode eine Vielzahl von Schaltoperationen notwendig. Die hohe Anzahl von Schaltoperationen wirkt sich jedoch wegen der Vielzahl von Übergängen von Sättigung zu Abschaltung und zurück negativ auf die Energieeffizienz aus, da nun umschalt-bedingte Verluste stärker zum Tragen kommen. Weiterhin sind die Anforderungen an die Verarbeitungsgeschwindigkeit nicht ohne Weiteres zu erfüllen, so dass diese dem Einsatz von BPDSM im Gigahertz-Bereich und darüber entgegensteht.

Hochpass ΔΣM (HPΔΣM / HPDSM) erfordern Arbeitsfrequenzen, die mindestens zweimal so hoch sind wie die benötigte Trägerfrequenz, womit im Wesentlichen auch die Einschränkungen der BPDSM zutreffend sind.

Tiefpass ΔΣM (LPΔΣM / LPDSM) erfordert hingegen nicht die Verwendung von Frequenzen, welche höher sind als die benötigte Trägerfrequenz. Daher können LPDSM mittels üblicher Verfahren, z.B. auch mittels field-programmable gate array (FPGA) implementiert werden. Allerdings ist zu verzeichnen, dass für niedrige Arbeitsfrequenzen (und damit einhergehend geringem Oversampling) LPΔΣM ein höheres Rauschen außerhalb des Nutzbandes aufweisen als HPΔΣM oder BPΔΣM, welche auf höheren Frequenzen arbeiten. Dabei tritt häufig der Fall auf, dass das Rauschsignal nahe am gewünschten Signal auftritt. Dieser Fall tritt insbesondere bei Signalen großer Bandbreite auf.

Ausgehend von dieser Situation ist es Aufgabe der Erfindung eine neue Senderfrontendvorrichtung zur Verfügung zu stellen, die es ermöglicht selbst bei geringen Arbeitsfrequenzen des DSM ein verbessertes Rauschverhalten zu zeigen.

Die Aufgabe wird gelöst, durch eine Senderfrontendvorrichtung gemäß Anspruch 1. Weitere vorteilhafte Ausgestaltungen sind insbesondere Gegenstand der abhängigen Ansprüche.

Nachfolgend wird die Erfindung näher unter Bezug auf die Figuren erläutert. In diesen zeigt:

Fig. 1     eine schematische Darstellung eines DSM,
Fig. 2     eine schematische Darstellung eines DSM-Konzeptes gemäß dem Stand der Technik,
Fig. 3     eine detaillierter schematische Darstellung eines DSM-Konzeptes gemäß dem Stand der Technik,
Fig. 4     eine detaillierter schematische Darstellung eines DSM-Konzeptes gemäß dem Stand der Technik,
Fig. 5     eine schematische Darstellung eines digitalen Signalraumes,
Fig. 6     eine schematische Darstellung eines DSM-Konzeptes gemäß Ausführungsformen der Erfindung,
Fig. 7     eine schematische Darstellung eines DSM-Konzeptes gemäß Ausführungsformen der Erfindung,
Fig. 8     eine schematische Darstellung eines DSM-Konzeptes gemäß Ausführungsformen der Erfindung,
Fig. 9     Meß-Ergebnisse an einem DSM-Konzept gemäß dem Stand der Technik,
Fig. 10     Meß-Ergebnisse an einem DSM-Konzept gemäß Ausführungsformen der Erfindung,
Fig. 11     detailliertere Meß-Ergebnisse an einem DSM-Konzept gemäß dem Stand der Technik,

Fig. 12     detailliertere Meß-Ergebnisse an einem DSM-Konzept gemäß Ausführungsformen der Erfindung.

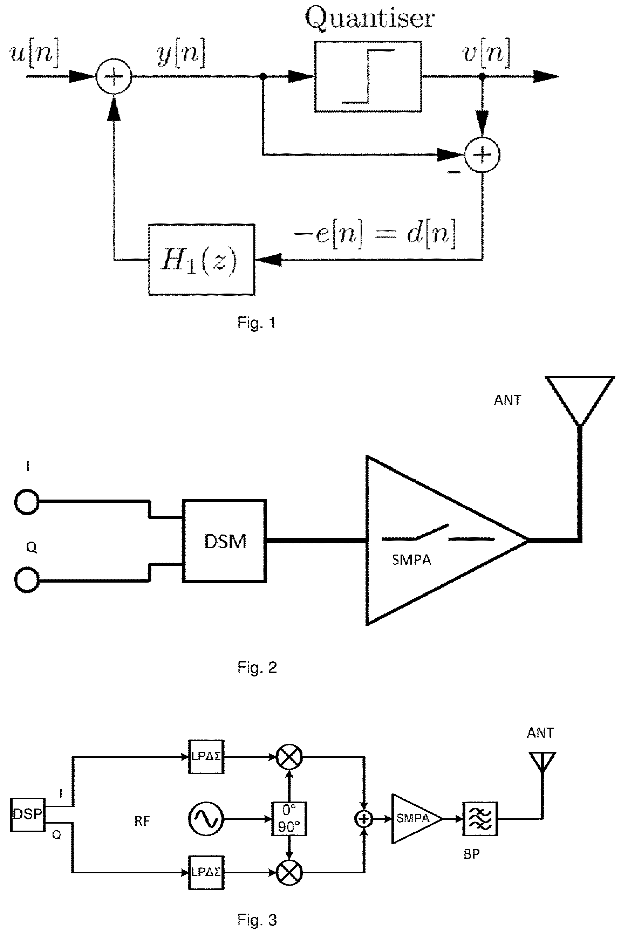

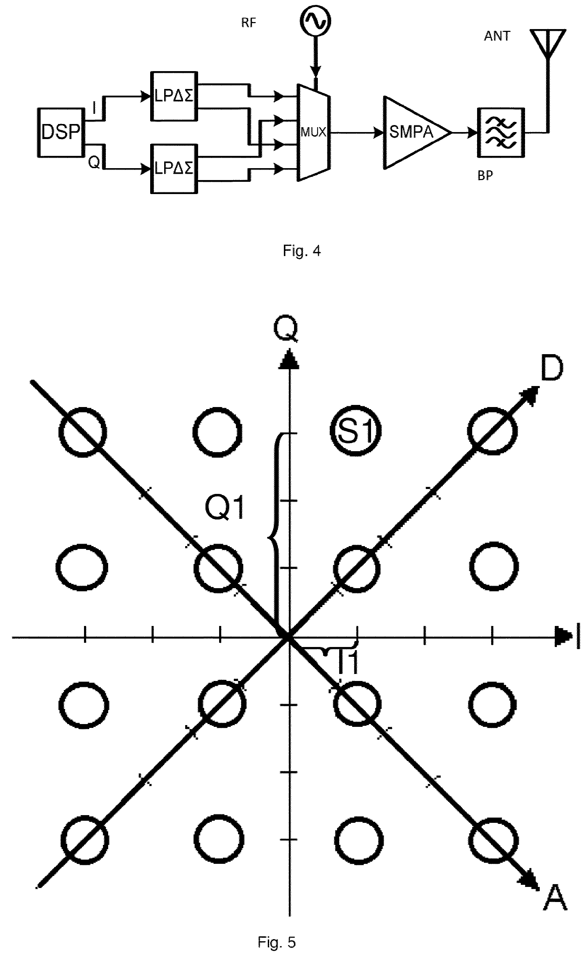

In Figur 2 ist ein DSM-Konzept gemäß dem Stand der Technik dargestellt. Dort werden von einem DSM Inphasensignale I und Quadraturphasensingale Q erhalten, die Signalpunkten entsprechen. Derartige Signalpunkte sind in Figur 5 dargestellt. Dort ist einem Signalpunkt S1 durch ein Inphasensignal I1 und ein Quadraturphasensignal Q1 referenziert. Am Ausgang des DSM steht der Einbit-Strom zur Verfügung und wird dem Schaltverstärker zur Verfügung gestellt. Das verstärkte Signal wird nun zur Antenne ANT geführt, um abgestrahlt zu werden. In Figur 3 ist eine detaillierte schematische Darstellung eines DSM-Konzeptes gemäß dem Stand der Technik dargestellt. Dort werden die Inphasensignale I und Quadraturphasensingale Q durch eine Digitale Signalverarbeitung DSP erzeugt und anschließend einem unabhängigen Tiefpass-DSM LPΔΣ zugeführt. Anschließend werden die Signale mit einem Hochfrequenzsignal RF umgesetzt, welches gegenüber einem der beiden Signale (dargestellt beim Q-Signal) um 90°phasenverschoben ist. Die jeweiligen aus dieser Umsetzung erhaltenen Signale werden in einer geeigneten Einrichtung, welche mit + gekennzeichnet ist, zusammengeführt und anschließend dem Schaltverstärker SMPA zur Verfügung gestellt. Das verstärkte Signal wird nun über ein Bandpassfilter BP in die analoge bzw. zeitkontinuierliche Domäne gewandelt und zur Antenne ANT geführt, um abgestrahlt zu werden.

In Figur 4 ist dieses Konzept noch weiter detailliert. Dort wird durch die LPΔΣ-Modulatoren ein komplementäres Phasensignalpaar erzeugt. Anschließend werden die Signale mit einem Hochfrequenzsignal RF umgesetzt. Die jeweiligen aus dieser Umsetzung erhaltenen Signale werden in einer geeigneten Einrichtung, welche mit MUX gekennzeichnet ist, auch zusammengeführt und anschließend dem Schaltverstärker SMPA zur Verfügung gestellt. Das verstärkte Signal wird nun über ein Bandpassfilter BP in die analoge Domäne gewandelt und zur Antenne ANT geführt, um abgestrahlt zu werden.

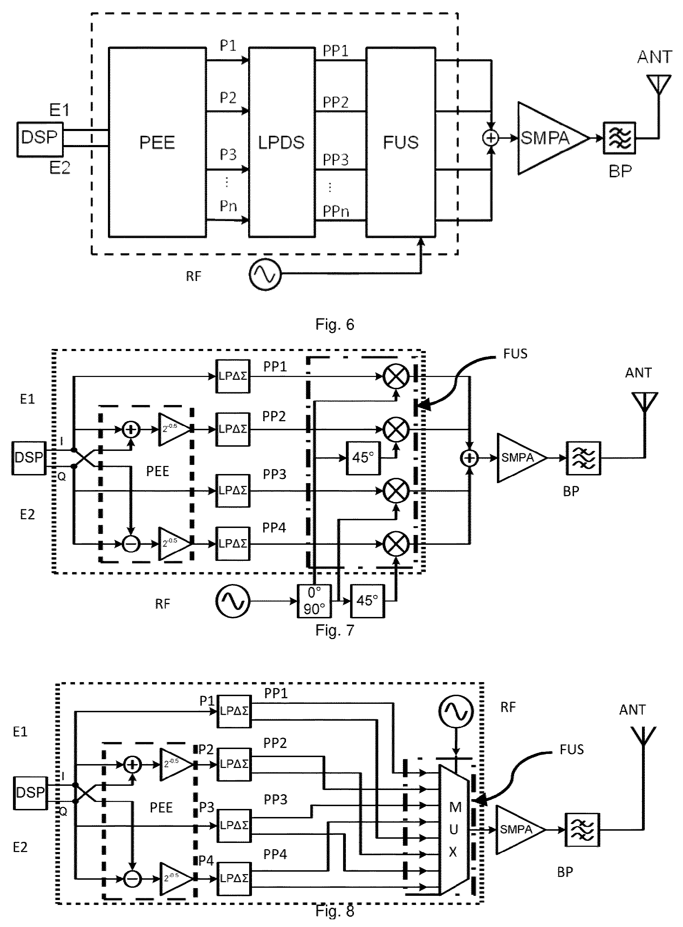

Nachfolgend werden an Hand der Figuren 6 bis 8 erfindungsgemäße beispielhafte Ausführungsformen näher erläutert werden.

Die Erfindungsgemäßen Ausführungsformen der Senderfrontendvorrichtung zur Erzeugung von Ausgangssignalen, welche einen digitalen Strom darstellen, weisen zumindest einen ersten Eingang E1 für ein erstes Eingangssignal und zumindest einen zweiten Eingang E2 für ein zweites Eingangssignal, wobei das erste Eingangssignal und das zweite Eingangssignal ein komplexes Datensignal des digitalen Stromes repräsentieren und ein Ausgangssignal der Senderfrontendvorrichtung beeinflussen sollen.

Dabei können die Eingangssignale z.B. ein Inphasensignal I und ein Quadraturphasensignal, Q, oder ein Amplitudensignal A und ein Phasensignal phi, oder eine geeignete Kombination hiervon, z.B. I, Q, und phi, aufweisen.

Weiterhin weist die Senderfrontendvorrichtung wenigstens eine Phasenerzeugungseinrichtung PEE auf, welche auf Basis des ersten Eingangssignales E1 und des zweiten Eingangssignales E2 wenigstens ein weiteres Phasensignal P1, P2, P3, ...

Pn erzeugt, wobei zumindest 3 Phasensignale P1, P2, P3, ... Pn mit unterschiedlichen Phasen zueinander von der Phasenerzeugungseinrichtung ausgegeben werden.

So ist es z.B. möglich, aus einem I und einem Q Signal zwei weitere Phasensignale P1 und P2 zu erzeugen, die gegenüber dem I Signal um +120° bzw. -120° phasenverschoben sind, während P3 dem I Signal entspricht. Andere Varianten werden nachfolgend detaillierter erläutert werden.

Weiterhin weist die Senderfrontendvorrichtung wenigstens einen geeigneten Modulator LPDS auf, der so eingerichtet ist, dass er aus einem erhaltenen Phasensignal P1, P2, P3, ... Pn, ein komplementäres Phasensignalpaar PP1, PP2, PP3, ... PPn erzeugt. Ein möglicher geeigneter Modulator ist ein DeltaSigma- oder ein Neoteric-Modulator.

Dabei kann je nach zur Verfügung stehender Arbeitsgeschwindigkeit eine parallele Verarbeitung von allen erhaltenen Phasensignalen P1, P2, P3, ... Pn durch eine gleich große Anzahl von einzelnen zugeordneten DeltaSigma-Modulatoren erfolgen, oder aber alle erhaltenen Phasensignalen P1, P2, P3, ... Pn werden sequentiell durch einen Modulator verarbeitet, insofern ist der Modulator durch seine sequentielle Verarbeitungsweise für jedes der Phasensignale ein zeitlich zugeordneter Modulator. Darüber hinaus ist auch eine Gruppe von gekoppelten Modulatoren, bei denen die Rückkopplung und Filterung aller Phasen kombiniert ist, ein sogenannter Polyphasen-Modulator möglich. Selbstverständlich können auch Mischformen dieser Fälle vorgesehen sein.

Somit wird jedes der wenigstens 3 Phasensignale P1, P2, P3, ... Pn durch einen zugeordneten Modulator in ein entsprechendes komplementäres Phasensignalpaar PP1, PP2, PP3, ... PPn verarbeitet.

Weiterhin weist die Senderfrontendvorrichtung wenigstens einen Frequenzumsetzer FUS auf, der so eingerichtet ist, dass er Phasensignale eines komplementären Phasensignalpaares PP1, PP2, PP3, ... PPn mit einem Hochfrequenzsignal RF umsetzt, um eine Ausganssignal zu bilden.

Die Ausgangssignale können dann in einer geeigneten Einrichtung, welche mit + gekennzeichnet ist, zusammengeführt und anschließend dem Schaltverstärker oder auch einem gesättigten Verstärker SMPA zur Verfügung gestellt werden. Das Umsetzen und Zusammenführen kann auch in einem Schritt durchgeführt werden, beispielsweise durch einen geeigneten Multiplexer oder ein Schieberegister. Das verstärkte Signal wird nun über ein Bandpassfilter BP in die analoge bzw. zeitkontinuierliche Domäne gewandelt und zur Antenne ANT geführt, um abgestrahlt zu werden.

Dabei ergibt sich aus dem Frequenzumsetzer FUS und der zusammenführenden Einrichtung + die Funktion eines Serialisierers, d.h. aus einer Vielzahl von erhaltenen parallelen Ausgangssignalen aus den Sigma Delta Wandlern wird wieder ein serieller Einbit-Strom erzeugt.

D.h. in deutlichem Unterschied zu bisherigen LP-DSM Konzepten, wie sie in den Figuren 2 bis 4 beispielhaft dargestellt sind, werden in dem erfindungsgemäßen System 3 oder mehr Phasenkomponenten zugeordneten Modulatoren zugeführt.

In einer beispielhaften Ausführung, welche in Figur 7 dargestellt ist, wird dem ersten Eingang E1 eine Inphasensignal I und dem zweiten Eingang E2 ein Quadraturphasensignal Q zugeführt. Aus dem Inphasensignal I und dem Quadraturphasensignal werden 2 weitere Phasensignale P2 und P4. Das Phasensignal P1 entspricht dem Inphasensignal I während das Phasensignal P3 dem Quadraturphasensignal Q entspricht.

Das Phasensignal P2 wird aus der Addition des Inphasensignals I und des Quadraturphasensignals Q gewonnen. Das Phasensignal P4 wird aus der Differenz des Inphasensignals I und des Quadraturphasensignals Q gewonnen. Das Phasensignal P2, nachfolgend auch als Diagonalsignal D bezeichnet, entspricht der D-Achse in Figur 5 während das Phasensignal P4, nachfolgend auch als Antidiagonalsignal A bezeichnet, der A-Achse in Figur 5 entspricht. Um die Amplituden der Phasensignale P2 und P4 an die Phasensignale wieder anzugleichen, werden diese gewichtet. Vorliegend werden die Phasensignale P2 und P4 jeweils mit dem Faktor $1/\sqrt{2}$ gewichtet. Die Phasensignale P1, P2, P3, P4 weisen unterschiedliche Phasen zueinander auf.

Weiterhin weist die Senderfrontendvorrichtung wenigstens einen DeltaSigma-Modulator LPΔΣ auf, der so eingerichtet ist, dass er aus einem erhaltenen Phasensignal P1, P2, P3, P4, ein komplementäres Phasensignalpaar PP1, PP2, PP3, PP4 erzeugt. Dargestellt ist in Figur 7, dass pro Phasensignal ein beispielhafter DeltaSigma-Modulator LPΔΣ vorgesehen ist. Natürlich können - wie zuvor erläutert -aber auch andere Konfigurationen verwendet werden.

Somit wird jedes der 4 Phasensignale P1, P2, P3, P4 durch einen zugeordneten DeltaSigma-Modulator in ein entsprechendes komplementäres Phasensignalpaar PP1, PP2, PP3, PP4 verarbeitet.

Weiterhin weist die Senderfrontendvorrichtung wenigstens einen Frequenzumsetzer FUS auf, der so eingerichtet ist, dass er Phasensignale eines komplementären Phasensignalpaares PP1, PP2, PP3, PP4 mit einem Hochfrequenzsignal RF umgesetzt, um eine Ausganssignal zu bilden. Dabei wird das Phasensignal P2 (A) mit dem Hochfrequenzsignal RF mit einem Phasenversatz von 45° gegenüber P1 (I) umgesetzt. Das Phasensignal P3 (Q) wird mit einem Phasenversatz von 90° gegenüber P1 (I) umgesetzt. Das Phasensignal P4 (D) wird mit einem Phasenversatz von 135° gegenüber P1 (I) umgesetzt.

Die Ausgangssignale können dann in einer geeigneten Einrichtung, welche mit + gekennzeichnet ist, zusammengeführt und anschließend dem Schaltverstärker oder auch einem gesättigten Verstärker SMPA zur Verfügung gestellt werden. Das verstärkte Signal wird nun über ein Bandpassfilter BP in die analoge bzw. zeitkontinuierliche Domäne gewandelt und zur Antenne ANT geführt, um abgestrahlt zu werden.

Dabei kommt der Kombination aus Frequenzumsetzer FUS und zusammenführenden Einrichtung + die Funktion eines Serialisierers zu, d.h aus einer Vielzahl von erhaltenen parallelen Ausgangssignalen aus dem Delta Sigma Modulator wird wieder ein serieller Einbit-Strom erzeugt.

In Figur 8 ist eine weitere beispielhafte Ausführung dargestellt. Bei dieser wird dem ersten Eingang E1 eine Inphasensignal I und dem zweiten Eingang E2 ein Quadraturphasensignal Q zugeführt. Aus dem Inphasensignal I und dem Quadraturphasensignal werden 2 weitere Phasensignale P2 und P4. Das Phasensignal P1 entspricht dem Inphasensignal I während das Phasensignal P3 dem Quadraturphasensignal Q entspricht.

Das Phasensignal P2 wird aus der Addition des Inphasensignals I und des Quadraturphasensignals Q gewonnen. Das Phasensignal P4 wird aus der Differenz des Inphasensignals I und des Quadraturphasensignals Q gewonnen. Das Phasensignal P2, nachfolgend auch als Diagonalsignal D bezeichnet, entspricht der D-Achse in Figur 5 während das Phasensignal P4, nachfolgend auch als Antidiagonalsignal A bezeichnet, der A-Achse in Figur 5 entspricht. Um die Amplituden der Phasensignale P2 und P4 an die Phasensignale wieder anzugleichen, werden diese gewichtet. Vorliegend werden die Phasensignale P2 und P4 jeweils mit dem Faktor $1/\sqrt{2}$ gewichtet. Die Phasensignale P1, P2, P3, P4 weisen unterschiedliche Phasen zueinander auf.

Weiterhin weist die Senderfrontendvorrichtung wenigstens einen beispielhaften DeltaSigma-Modulator LP$\Delta\Sigma$ auf, der so eingerichtet ist, dass er aus einem erhaltenen Phasensignal P1, P2, P3, P4, ein komplementäres Phasensignalpaar PP1, PP2, PP3, PP4 erzeugt. Dargestellt ist in Figur 8, dass pro Phasensignal ein DeltaSigma-Modulator LP$\Delta\Sigma$ vorgesehen ist. Natürlich können - wie zuvor erläutert -aber auch andere Konfigurationen verwendet werden.

Somit wird jedes der 4 Phasensignale P1, P2, P3, P4 durch einen zugeordneten DeltaSigma-Modulator in ein entsprechendes komplementäres Phasensignalpaar PP1, PP2, PP3, PP4 verarbeitet.

Weiterhin weist die Senderfrontendvorrichtung wenigstens einen Frequenzumsetzer FUS auf, der so eingerichtet ist, dass er Phasensignale eines komplementären Phasensignalpaares PP1, PP2, PP3, PP4 mit einem Hochfrequenzsignal RF umsetzt, um ein Ausganssignal zu bilden. Dabei wird das Phasensignal P2 (A) mit dem Hochfrequenzsignal RF mit einem Phasenversatz von 45° gegenüber P1 (I) umgesetzt. Das Phasensignal P3 (Q) wird mit einem Phasenversatz von 90° gegenüber P1 (I) umgesetzt. Das Phasensignal P4 (D) wird mit einem Phasenversatz von 135° gegenüber P1 (I) umgesetzt.

Die Ausgangssignale können dann in herkömmlicher Weise in einer geeigneten Einrichtung, welche in diesem Fall als MUX gekennzeichnet und als Bestandteil des Frequenzumsetzers FUS ausgeführt ist, zusammengeführt und anschließend dem Schaltverstärker SMPA zur Verfügung gestellt werden. Das verstärkte Signal wird nun über ein Bandpassfilter BP in die analoge Domäne gewandelt und zur Antenne ANT geführt, um abgestrahlt zu werden.

Dabei kommt der mit MUX gekennzeichneten Komponente die Funktion eines Serialisierers zu, d.h aus einer Vielzahl von erhaltenen parallelen Ausgangssignalen aus dem Frequenzumsetzer FUS wird wieder ein serieller Einbit-Strom erzeugt.

Durch die Erzeugung von zwei weiteren Phasensignalen ist es nun möglich, die Zeitauflösung zu erhöhen. Hierdurch wird das Signal-Rauschverhältnis gegenüber dem bisher bekannten Ausführungsformen gemäß Figuren 2 bis 4 deutlich verbessert.

In den Ausführungsformen gemäß der Figuren 7 und 8 wird nun die bisherige Sequenz $IQ\overline{IQ}$, welche am Eingang der Frequenzumsetzung FUS anliegt, beispielsweise zu der Sequenz $IDQA\overline{IDQA}$ erweitert. Hierdurch ermöglicht die Erfindung die Vorteile von Tiefpass-DeltaSigma-Modulatoren mit ihren geringeren Anforderungen an die Signalverarbeitungsgeschwindigkeit zu nutzen und das Signal-Rausch-Verhältnis zu verbessern, wodurch selbst eine Implementierung in FPGA ermöglicht wird.

Zu Demonstrationszwecken wurde eine Signalerzeugung DSP, $\Delta\Sigma$-Modulatoren und die Aufwärtskonversion in einem FPGA implementiert. Dabei wurde zu Vergleichszwecken ein herkömmliches Design wie in Figur 4 dargestellt als auch ein erfindungsgemäßes Design, wie es in Figur 7 dargestellt ist, implementiert. Als Eingangssignal wurde ein komplexes Einseitenband-Signal mit einstellbarer Frequenz $f_{st}$ erzeugt, mit $I = \sin(2\pi f_{st}t)$ bzw. $Q = \cos(2\pi f_{st}t)$. Um die maximale Geschwindigkeit zu erreichen, wurde das auf dem FPGA

verfügbare DDS-Core verwendet, wodurch im gegebenen Beispiel eine maximale Taktfrequenz von 400 MHz erreicht werden kann. Die zusätzlichen Phasensignal P2, P4, bzw. D und A, können in diesem Fall in unter Verwendung eines "pipelined combined adder/multiplier block" erzeugt werden, wodurch ebenfalls die Taktfrequenz von 400 MHz erreichbar ist. Als verwendete $\Delta\Sigma M$ Topologie wurde ein Tiefpass- DeltaSigma-Modulator erster Ordnung mit einem dreistufigen Ausgang gewählt. Die drei Ausgangslevel wurden dadurch implementiert, dass die Ausgangssignale $v$ für $I$ und $Q$ und deren komplementären Signale $\overline{v}$ für $\overline{I}$ und $\overline{Q}$ unabhängig gesteuert werden. Hierdurch wird eine effektive Auflösung der DeltaSigma-Modulatoren von 1.5 bit erreicht. Um die Berechnung zu optimieren wurde das Fehlersignal e direkt aus den "least significant bits", hier von sig-2 to 0 kombiniert mit dem signum bit des $\Delta\Sigma$ Eingangswortes y erzeugt. Dieses Fehlersignal $e = y_{sig}$, $y_{sig-2...0}$ wird dann im nächsten Taktzyklus dem Eingang hinzugefügt. Das Ausgangssignal ergibt sich nun aus dem signum und den "most significant bit", hier sig-1, zu $v = \neg y_{sig} \wedge y_{sig-1}$ bzw. $\overline{v} = y_{sig} \wedge \neg y_{sig-1}$. Diese vereinfachte Berechnung erlaubt die Berechnung bei der maximalen Taktfrequenz. Die nachfolgende Aufwärtskonvertierung (upconversion) wird durch ein RocketIO transceiver bereitgestellt, der eine parallele Bytesequenz in einen seriellen Bitstrom mit einer Sampling-Frequenz von hier $f_{ser}$=3.2 GHz zur Verfügung stellt. Der Eingangsbytestrom kann somit als ein digitales Poly-Phasen Basisbandsignal aufgefasst werden, wobei das Eingangsbyte einen Zyklus der Trägerfrequenz repräsentiert und wobei der Phasenwinkel zwischen zwei bits $\Delta\Phi = \dfrac{\pi}{4} = 45°$.

Hieraus ergibt sich eine Trägerfrequenz

$$f_c = \frac{\Delta\Phi}{2\pi} f_{ser} = 400 MHz.$$ Bei einer Implementierung auf einem Hochfrequenzschaltkreis kann der Serialisierer in einem eigenen Design entworfen werden. So ist es z.B. möglich, wie in der Figur 8 gezeigt, einen Multiplexer MUX zu verwenden, der z.B. mittels einer Verzögerungsschleife gesteuert wird und somit als Hochgeschwindigkeits-Serialisierer verwendet werden kann, wodurch Trägerfrequenzen auch im Gigahertz-Bereich ermöglicht werden.

Obwohl vorstehend ganz allgemein von Eingangssignalen die Rede war, versteht es sich, dass die Senderfrontendvorrichtung gemäß den Ausführungsformen der Erfindung auch analoge Signale im Prinzip verarbeitet werden können. Gleichfalls ist es möglich auch Signale mit einer höheren digitalen Auflösung, zumindest jedoch digital binäre Signale, zu verarbeiten.

Obwohl vorstehend ganz allgemein von Phasensignalen bzw. von ternären Phasensignalen die Rede war, versteht es sich, dass die Senderfrontendvorrichtung gemäß den Ausführungsformen der Erfindung auch Phasensignale binärer Form oder höherer Auflösung erzeugen kann.

Obwohl vorstehend beispielhaft DeltaSigma-Modulatoren beschrieben wurden, sind auch andere Modulatoren, die aus dem Eingangssignal ein Phasensignal mit im Wesentlichen konstanter Amplitude erzeugen, wobei zum Eingangssignal weitere Signale so hinzugefügt werden, dass diese in entsprechender Ablage zum gewünschten Frequenzband zu liegen kommen und somit leicht am Systemausgang herausgefiltert werden können. Ein anderes Beispiel für solch eine Art Modulator ist ein Neoteric-Modulator.

Im Allgemeinen ist vorgesehen, dass die Phasenbeziehung benachbarter unterschiedlicher Phasen gleich ist. So ist die Phasenbeziehung in den Ausführungsformen gemäß Figur 7 und 8 so, dass P2 zu P1, P3 zu P2, P4 zu P3 jeweils um 45° phasenverschoben ist. Andere Phasenbeziehungen sind jedoch durch die Erfindung nicht ausgeschlossen.

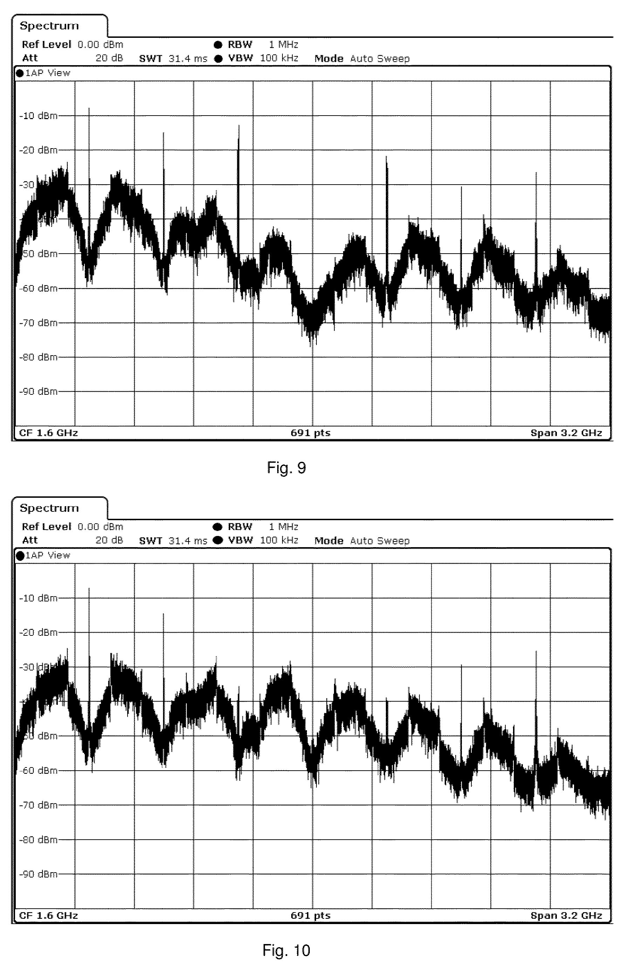

Abschließend sollen nachfolgend beispielhafte Messergebnisse dargestellt werden, die die Ausführbarkeit der Erfindung an Hand der zuvor beschriebenen beispielhaften Implementierung unter Beweis stellen. Dabei wird die Arbeitsfrequenz des $\Delta\Sigma M$ zu 400 MHz gewählt. Diese Frequenz ist auch die Trägerfrequenz des Serialisierers. Die Frequenz des komplexen Einseitenband-Signals wurde zu einer niedrigen Frequenz von 1 kHz gewählt, um Artefakte eines digitalen Resamplings zu vermeiden. In Fig. 10 ist das Breitbandspektrum des Vierphasenfrontends gemäß Figur 8 gezeigt. Zum Vergleich hierzu ist in Figur 9 das Breitbandspektrum eines konventionellen Ansatzes bei gleichem Eingangssignal gemäß Figur 2 bis 4 gezeigt. Dabei wird deutlich, dass Rauschen in Bereiche von 1.6 GHz verschoben wurde und somit das Rauschen gleichförmiger oberhalb der Trägerfrequenz als in Figur 9 verteilt ist.

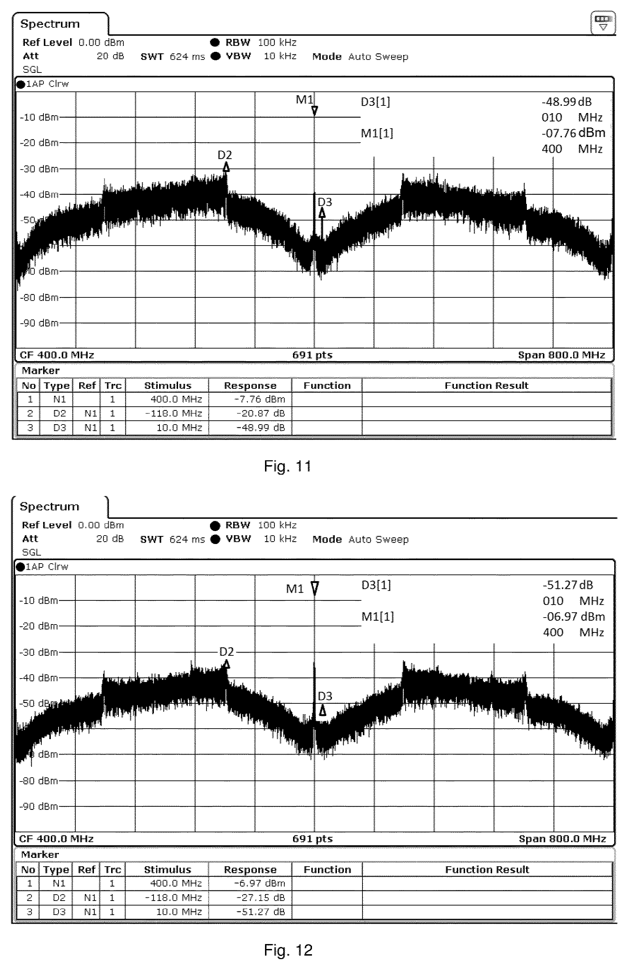

In den Figuren 11 und 12 sind detailliertere Meß-Ergebnisse gezeigt. Dabei zeigt Figur 11 wiederum den konventionellen Ansatz während Figur 12 den erfindungsgemäßen Ansatz visualisiert. Dabei tritt die bessere Rauschunterdrückung zu Tage. Bei einer Ablage von circa 118 MHz wird das Maximale Rauschen um 6 dB verringert. Das Signal-Rausch-Verhältnis gemessen bei 10 MHz Ablage zum gewünschten Signal, welches in Figur 11 und 13 mit D3 bezeichnet ist, wurde um 3 dB verbessert. Weiterhin erlaubt die vorgestellte Anordnung auch die Signalleistung um circa 1 dB gegenüber dem konventionellen Ansatz zu erhöhen.

Im Ergebnis zeigt sich, dass die vorgestellte erfindungsgemäße Anordnung die Anforderungen selbst bei geringen Arbeitsfrequenzen des DSM ein verbessertes Rauschverhalten zu zeigen.

**Patentansprüche**

1. Senderfrontendvorrichtung zur Erzeugung von Ausgangssignalen, welche einen digitalen Strom darstellen, wobei die Vorrichtung aufweist:

   • Zumindest einen ersten Eingang für ein erstes Eingangssignal und zumindest einen zweiten Eingang für ein zweites Eingangssignal, wobei das erste Eingangssignal und das zweite Eingangssignal ein komplexes Datensignal des digitalen Stromes repräsentieren und ein Ausgangssignal der Senderfrontendvorrichtung beeinflussen sollen,
   • Wenigstens eine Phasenerzeugungseinrichtung, welche auf Basis des ersten Eingangssignales und des zweiten Eingangssignales wenigstens ein weiteres Phasensignal erzeugt, wobei zumindest 3 Phasensignale mit unterschiedlichen Phasen zueinander von der Phasenerzeugungseinrichtung ausgegeben werden,

• Wenigstens einen Modulator, der so eingerichtet ist, dass er aus einem erhaltenen Phasensignal, ein komplementäres Phasensignalpaar erzeugt,

• Wobei jedes der wenigstens 3 Phasensignale durch einen zugeordneten -Modulator in ein entsprechendes komplementäres Phasensignalpaar verarbeitet wird,

• Wenigstens einen Frequenzumsetzer, der so eingerichtet ist, dass er Phasensignale eines komplementären Phasensignalpaares Frequenz umsetzt, um ein Ausgangssignal zu bilden.

2. Senderfrontendvorrichtung nach Anspruch 1, **dadurch gekennzeichnet, dass** das erste Eingangssignal und das zweite Eingangssignal zumindest digital binär ist.

3. Senderfrontendvorrichtung nach Anspruch 1 oder 2, **dadurch gekennzeichnet, dass** die erzeugten Phasensignale zumindest digital binär sind.

4. Senderfrontendvorrichtung nach einem der vorhergehenden Ansprüche, **dadurch gekennzeichnet, dass** die Phasenbeziehung benachbarter unterschiedlicher Phasen gleich ist.

5. Senderfrontendvorrichtung nach einem der vorhergehenden Ansprüche, **dadurch gekennzeichnet, dass** pro Phasensignal eine Phasenerzeugungseinrichtung vorgesehen ist.

6. Senderfrontendvorrichtung nach einem der vorhergehenden Ansprüche, **dadurch gekennzeichnet, dass** die Phasenerzeugungseinrichtung aus dem Inphasensignal und dem Quadraturphasensignal zumindest zwei weitere hasensignale erzeugt, wobei eins der erzeugten Phasensignale auf der Summe des Inphasensignals und des Quadraturphasensignals basiert und wobei die andere der erzeugten Phasensignale auf der Differenz des Inphasensignals und des Quadraturphasensignals basiert.

7. Senderfrontendvorrichtung nach einem der vorhergehenden Ansprüche, **dadurch gekennzeichnet, dass** zumindest pro Phasensignalpaar ein Frequenzumsetzer vorgesehen ist.

8. Senderfrontendvorrichtung nach einem der vorhergehenden Ansprüche, **dadurch gekennzeichnet, dass** die erzeugten Ausgangssignale in einem Kombinierer zu einem zu sendenden Ausgangssignal zusammengeführt werden.

9. Senderfrontendvorrichtung nach einem der vorhergehenden Ansprüche, **dadurch gekennzeichnet, dass** die Phasensignalpaare jeweils ein ternäres Format aufweisen.

10. Senderfrontendvorrichtung nach einem der vorhergehenden Ansprüche, **dadurch gekennzeichnet, dass** der Modulator ein Delta-Sigma Modulator oder ein Neoteric Modulator ist.

**Claims**

1. A transmitter front-end device for generating output signals, which constitute a digital stream, wherein the device comprises:

   • at least one first input for a first input signal and at least one second input for a second input signal, wherein the first input signal and the second input signal represent a complex data signal of the digital stream and are intended to influence an output signal of the transmitter front-end device,
   • at least one phase generation means, which generates at least one additional phase signal on basis of the first input signal and of the second input signal, wherein at least 3 phase signals are output from the phase generation means with different phases with respect to each other,
   • at least one modulator, which is set up such that it generates a complementary phase signal pair from a received phase signal,
   • wherein each of the at least 3 phase signals is processed into a corresponding complementary phase signal pair by an associated modulator,
   • at least one frequency converter, which is set up such that it converts the frequency of phase signals of a complementary phase signal pair in order to form an output signal.

2. The transmitter front-end device according to Claim 1, **characterised in that** the first input signal and the second input signal are at least digitally binary.

3. The transmitter front-end device according to Claim 1 or 2, **characterised in that** the generated phase signals are at least digitally binary.

4. The transmitter front-end device according to one of the preceding claims, **characterised in that** the phase relationship of neighbouring different phases is equal.

5. The transmitter front-end device according to one of the preceding claims, **characterised in that** a phase generation means is provided for each phase signal.

**6.** The transmitter front-end device according to one of the preceding claims, **characterised in that** the phase generation means generates at least two additional phase signals from the in-phase signal and the quadrature phase signal, wherein one of the generated phase signals is based on the sum of the in-phase signal and the quadrature phase signal, and wherein the other of the generated phase signals is based on the difference of the in-phase signal and the quadrature phase signal.

**7.** The transmitter front-end device according to one of the preceding claims, **characterised in that** a frequency converter is provided at least for each phase signal pair.

**8.** The transmitter front-end device according to one of the preceding claims, **characterised in that** the generated output signals are merged in a combiner into an output signal to be transmitted.

**9.** The transmitter front-end device according to one of the preceding claims, **characterised in that** each of the phase signal pairs has a ternary format.

**10.** The transmitter front-end device according to one of the preceding claims, **characterised in that** the modulator is a delta-sigma modulator or a neoteric modulator.

**Revendications**

**1.** Dispositif frontal d'émission pour la génération de signaux de sortie, lesquels représentent un flux numérique, dans lequel le dispositif comprenant :

• au moins une première entrée pour un premier signal d'entrée et au moins une deuxième entrée pour un deuxième signal d'entrée, dans lequel le premier signal d'entrée et le deuxième signal d'entrée représentent un signal de données complexe du flux numérique et doivent influencer un signal de sortie du dispositif frontal d'émission,
• au moins un dispositif de génération de phases, lequel génère, sur la base du premier signal d'entrée et du deuxième signal d'entrée, au moins un autre signal de phase, dans lequel au moins 3 signaux de phase avec des phases différentes les unes des autres sont émis par le dispositif de génération de phases,
• au moins un modulateur, lequel est étudié de manière à générer, à partir d'un signal de phase obtenu, une paire de signaux de phase complémentaires,
• dans lequel chacun des au moins 3 signaux de phase est transformé par un modulateur associé en une paire correspondante de signaux de phase complémentaires,
• au moins un convertisseur de fréquence, lequel est étudié de manière à convertir des signaux de phase d'une paire de signaux de phase complémentaires afin de former un signal de sortie.

**2.** Dispositif frontal d'émission selon la revendication 1, **caractérisé en ce que** le premier signal d'entrée et le deuxième signal d'entrée sont au moins numériques binaires.

**3.** Dispositif frontal d'émission selon la revendication 1 ou 2, **caractérisé en ce que** les signaux de phase générés sont au moins numériques binaires.

**4.** Dispositif frontal d'émission selon l'une des revendications précédentes, **caractérisé en ce que** la relation de phase de phases différentes voisines est égale.

**5.** Dispositif frontal d'émission selon l'une des revendications précédentes, caractérisé que l'on prévoit un dispositif de génération de phases par signal de phase.

**6.** Dispositif frontal d'émission selon l'une des revendications précédentes, **caractérisé en ce que** le dispositif de génération de phases génère à partir du signal en phase et du signal de phase en quadrature au moins deux autres signaux de phase, dans lequel l'un des signaux de phase générés est basé sur la somme du signal en phase et du signal de phase en quadrature, et dans lequel l'autre des signaux de phase générés est basé sur la différence entre le signal en phase et le signal de phase en quadrature.

**7.** Dispositif frontal d'émission selon l'une des revendications précédentes, **caractérisé en ce que** l'on prévoit au moins un convertisseur de fréquence par paire de signaux de phase.

**8.** Dispositif frontal d'émission selon l'une des revendications précédentes, **caractérisé en ce que** les signaux de sortie générés sont réunis dans un combineur pour donner un signal de sortie à envoyer.

**9.** Dispositif frontal d'émission selon l'une des revendications précédentes, **caractérisé en ce que** les paires de signaux de phase présentent respectivement un format ternaire.

**10.** Dispositif frontal d'émission selon l'une des revendications précédentes, **caractérisé en ce que** le modulateur est un modulateur sigma-delta ou un modulateur néotérique.

## Quantiser

$$u[n] \qquad y[n] \qquad v[n]$$

$$-e[n] = d[n]$$

$$H_1(z)$$

Fig. 1

I

Q

DSM

SMPA

ANT

Fig. 2

DSP

I

Q

RF

LPΔΣ

LPΔΣ

0°
90°

SMPA

BP

ANT

Fig. 3

Fig. 4

Fig. 5

Fig. 6

Fig. 7

Fig. 8

Fig. 9

Fig. 10

**Spectrum**

Ref Level 0.00 dBm  ● RBW 100 kHz
Att 20 dB  SWT 624 ms ● VBW 10 kHz  Mode Auto Sweep
SGL

●1AP Clrw

M1  D3[1]  -48.99 dB
010 MHz
M1[1]  -07.76 dBm
400 MHz

CF 400.0 MHz  691 pts  Span 800.0 MHz

**Marker**

| No | Type | Ref | Trc | Stimulus | Response | Function | Function Result |
|----|------|-----|-----|----------|----------|----------|-----------------|
| 1 | N1 | | 1 | 400.0 MHz | -7.76 dBm | | |
| 2 | D2 | N1 | 1 | -118.0 MHz | -20.87 dB | | |
| 3 | D3 | N1 | 1 | 10.0 MHz | -48.99 dB | | |

Fig. 11

**Spectrum**

Ref Level 0.00 dBm  ● RBW 100 kHz
Att 20 dB  SWT 624 ms ● VBW 10 kHz  Mode Auto Sweep
SGL

●1AP Clrw

M1  D3[1]  -51.27 dB
010 MHz
M1[1]  -06.97 dBm
400 MHz

CF 400.0 MHz  691 pts  Span 800.0 MHz

**Marker**

| No | Type | Ref | Trc | Stimulus | Response | Function | Function Result |
|----|------|-----|-----|----------|----------|----------|-----------------|
| 1 | N1 | | 1 | 400.0 MHz | -6.97 dBm | | |
| 2 | D2 | N1 | 1 | -118.0 MHz | -27.15 dB | | |
| 3 | D3 | N1 | 1 | 10.0 MHz | -51.27 dB | | |

Fig. 12

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2004192229 A1